(19) Europäisches Patentamt
European Patent Office
Office européen des brevets

(11) **EP 3 990 933 B1**

(12) **FASCICULE DE BREVET EUROPEEN**

(45) Date de publication et mention
de la délivrance du brevet:
**25.03.2026  Bulletin 2026/13**

(21) Numéro de dépôt: **20731115.0**

(22) Date de dépôt: **11.06.2020**

(51) Classification Internationale des Brevets (IPC):
**G01R 31/11** *(2006.01)*      **G01R 31/54** *(2020.01)*

(52) Classification Coopérative des Brevets (CPC):
**G01R 31/11;** G01R 31/54

(86) Numéro de dépôt international:
**PCT/EP2020/066178**

(87) Numéro de publication internationale:
**WO 2020/260031 (30.12.2020 Gazette 2020/53)**

(54) **METHODE DE REDUCTION DE LA PUISSANCE CRETE D'UN SIGNAL DE REFLECTOMETRIE MULTI-PORTEUSES**

VERFAHREN ZUR REDUZIERUNG DER SPITZENLEISTUNG EINES MEHRTRÄGER-REFLEKTOMETRIESIGNALS

METHOD FOR REDUCING THE PEAK POWER OF A MULTI-CARRIER REFLECTOMETRY SIGNAL

(84) Etats contractants désignés:
AL AT BE BG CH CY CZ DE DK EE ES FI FR GB GR HR HU IE IS IT LI LT LU LV MC MK MT NL NO PL PT RO RS SE SI SK SM TR

(30) Priorité: **26.06.2019  FR 1906962**

(43) Date de publication de la demande:
**04.05.2022  Bulletin 2022/18**

(73) Titulaire: **Commissariat à l'Energie Atomique et aux Energies Alternatives**
**75015 Paris (FR)**

(72) Inventeurs:
• **DUPRET, Antoine**
**91400 ORSAY (FR)**
• **CABANILLAS, Esteban**
**38120 SAINT-EGREVE (FR)**
• **DUVILLIER, Hugues**
**52800 POULANGY (FR)**

(74) Mandataire: **Atout PI Laplace**
**Immeuble Up On**
**25 Boulevard Romain Rolland**
**CS 40072**
**75685 Paris Cedex 14 (FR)**

(56) Documents cités:
• MATHIAS FRIESE: "Multitone Signals with Low Crest Factor", IEEE TRANSACTIONS ON COMMUNICATIONS, IEEE SERVICE CENTER, PISCATAWAY, NJ. USA, vol. 45, no. 10, 1 October 1997 (1997-10-01), XP011009032, ISSN: 0090-6778
• CABANILLAS ESTEBAN ET AL: "Enhancing the Spatial Resolution for Wire Fault Detection Systems Using Multi-Carrier Signals", IEEE SENSORS JOURNAL, IEEE SERVICE CENTER, NEW YORK, NY, US, vol. 18, no. 23, 1 December 2018 (2018-12-01), pages 9857 - 9866, XP011705041, ISSN: 1530-437X, [retrieved on 20181112], DOI: 10.1109/JSEN.2018.2872409
• LEVY DAVID ET AL: "Peak to Average Power Ratio Reduction for Filter Bank Multicarrier Modulation using Iterative Clipping and Filtering", 2018 IEEE INTERNATIONAL CONFERENCE ON THE SCIENCE OF ELECTRICAL ENGINEERING IN ISRAEL (ICSEE), IEEE, 12 December 2018 (2018-12-12), pages 1 - 3, XP033521945, DOI: 10.1109/ICSEE.2018.8646205

- KULKARNI V M ET AL: "An overview of various techniques to reduce the Peak-to-average power ratio in multicarrier transmission systems", COMPUTATIONAL INTELLIGENCE&COMPUTING RESEARCH (ICCIC), 2012 IEEE INTERNATIONAL CONFERENCE ON, IEEE, 18 December 2012 (2012-12-18), pages 1 - 5, XP032390045, ISBN: 978-1-4673-1342-1, DOI: 10.1109/ ICCIC.2012.6510251
- MATHIAS FRIESE: "Multitone Signals with Low Crest Factor", IEEE TRANSACTIONS ON COMMUNICATIONS, IEEE SERVICE CENTER, PISCATAWAY, NJ. USA, vol. 45, no. 10, 1 October 1997 (1997-10-01), XP011009032, ISSN: 0090-6778
- CABANILLAS ESTEBAN ET AL: "Enhancing the Spatial Resolution for Wire Fault Detection Systems Using Multi-Carrier Signals", IEEE SENSORS JOURNAL, IEEE SERVICE CENTER, NEW YORK, NY, US, vol. 18, no. 23, 1 December 2018 (2018-12-01), pages 9857 - 9866, XP011705041, ISSN: 1530-437X, [retrieved on 20181112], DOI: 10.1109/JSEN.2018.2872409
- LEVY DAVID ET AL: "Peak to Average Power Ratio Reduction for Filter Bank Multicarrier Modulation using Iterative Clipping and Filtering", 2018 IEEE INTERNATIONAL CONFERENCE ON THE SCIENCE OF ELECTRICAL ENGINEERING IN ISRAEL (ICSEE), IEEE, 12 December 2018 (2018-12-12), pages 1 - 3, XP033521945, DOI: 10.1109/ ICSEE.2018.8646205
- KULKARNI V M ET AL: "An overview of various techniques to reduce the Peak-to-average power ratio in multicarrier transmission systems", COMPUTATIONAL INTELLIGENCE&COMPUTING RESEARCH (ICCIC), 2012 IEEE INTERNATIONAL CONFERENCE ON, IEEE, 18 December 2012 (2012-12-18), pages 1 - 5, XP032390045, ISBN: 978-1-4673-1342-1, DOI: 10.1109/ ICCIC.2012.6510251

## Description

L'invention concerne le domaine des systèmes de diagnostic filaires basés sur le principe de la réflectométrie pour identifier et caractériser des défauts électriques sur des câbles ou plus généralement des lignes de transmission. L'invention concerne plus précisément le domaine de la réflectométrie multi-porteuses qui utilise des signaux multi-porteuses générés à partir du principe de modulation OFDM (Orthogonal Frequency Division Multiplexing).

L'invention a pour objet une méthode permettant de générer un signal de réflectométrie multi-porteuses ayant un rapport entre puissance crête et puissance moyenne réduit par rapport à un signal multi-porteuses classique.

Les câbles sont omniprésents dans tous les systèmes électriques, pour l'alimentation ou la transmission d'information. Ces câbles sont soumis à des contraintes et peuvent être sujets à des défaillances. Il est donc nécessaire de pouvoir analyser leur état et d'apporter des informations sur la détection de défauts qui impactent ces câbles, ces informations incluant l'existence de défauts mais aussi leur localisation et leur type. L'analyse de défauts permet d'aider à la maintenance des câbles. Les méthodes de réflectométrie usuelles permettent ce type d'analyse.

Les méthodes de réflectométrie utilisent un principe proche de celui du radar : un signal électrique, le signal de sonde ou signal de référence, est injecté en un ou plusieurs endroits du câble à tester. Le signal se propage dans le câble ou le réseau de câbles et renvoie une partie de son énergie lorsqu'il rencontre une discontinuité électrique. Une discontinuité électrique peut résulter, par exemple, d'un branchement, de la fin du câble ou d'un défaut ou plus généralement d'une rupture des conditions de propagation du signal dans le câble. Elle résulte d'un défaut qui modifie localement l'impédance caractéristique du câble en provoquant une discontinuité dans ses paramètres linéiques.

L'analyse des signaux renvoyés au point d'injection permet d'en déduire des informations sur la présence et la localisation de ces discontinuités, donc des défauts éventuels. Une analyse dans le domaine temporel ou fréquentiel est habituellement réalisée. Ces méthodes sont désignées par les acronymes TDR venant de l'expression anglo-saxonne « Time Domain Reflectometry » et FDR venant de l'expression anglo-saxonne « Frequency Domain Reflectometry ».

La réflectométrie MCR (« MultiCarrier Reflectometry ») utilise des signaux multi-porteuses. Son intérêt est la grande flexibilité avec laquelle on peut moduler le spectre du signal émis, ce qui permet ainsi de s'adapter à des contraintes propres au diagnostic en ligne. Par exemple, s'il est interdit d'émettre sur une bande de fréquence située au milieu du spectre du signal test, il est tout à fait possible d'annuler l'énergie du signal sur cette bande de fréquences. On connait également la réflectométrie MCTDR (« MultiCarrier Time Domain Reflectometry »), comme décrit dans le document référencé [1].

L'invention entre dans le champ d'application des méthodes de diagnostic filaire par réflectométrie et s'applique à tout type de câble électrique, en particulier des câbles de transmission d'énergie ou des câbles de communication, dans des installations fixes ou mobiles. Les câbles concernés peuvent être coaxiaux, bifilaires, en lignes parallèles, en paires torsadées ou autre pourvu qu'il soit possible d'y injecter un signal de réflectométrie en un point du câble et de mesurer sa réflexion au même point ou en un autre point.

Un problème à résoudre dans un système de diagnostic filaire concerne l'atténuation que subit le signal injecté dans le câble à analyser, lorsqu'il se propage le long de ce câble jusqu'à rencontrer un défaut provoquant une réflexion. Le pic de réflexion est usuellement déterminé par inter-corrélation entre le signal injecté et le signal réfléchi. Lorsque le câble est long par rapport à la longueur d'onde du signal, celui-ci subit une atténuation lors de sa propagation et de sa rétro-propagation, qui est fonction de la distance parcourue par le signal. Cette atténuation présente un inconvénient majeur lors de l'étape d'analyse des signaux réfléchis, par réflectométrie temporelle, qui vise à identifier un pic d'amplitude dans le résultat de l'intercorrélation entre le signal émis et le signal réfléchi. En effet, plus le signal est atténué, plus il est difficile de détecter la signature d'un défaut dans la mesure du signal réfléchi. Ceci est d'autant plus vrai que le défaut visé est un défaut non franc, c'est-à-dire qui correspond à une faible rupture d'impédance, c'est-à-dire un défaut superficiel.

Pour limiter l'atténuation du signal lors de sa propagation dans un câble, il est donc souhaitable d'utiliser un amplificateur pour amplifier le signal avant son injection, afin de compenser les effets de l'atténuation.

Cependant, les amplificateurs de signaux ont un comportement non-linéaire qui entraine une saturation des valeurs élevées du signal à amplifier. Ce comportement non-linéaire est d'autant plus présent que le signal à amplifier présente un rapport entre puissance crête et puissance moyenne (ou PAPR pour Peak to Average Power Ratio) élevé. C'est le cas des signaux multi-porteuses comme les signaux OFDM (Orthogonal Frequency Division Multiplexing), ou les signaux spécifiquement dédiés à la réflectométrie tels que les signaux MCTDR (Multi-Carrier Time Domain Reflectometry) ou OMTDR (Orthogonal Multi-carrier Time Domain Reflectometry) qui sont basés sur le principe de l'OFDM.

Ce comportement non linéaire dégrade le rapport signal sur bruit des mesures réalisées ce qui produit un effet néfaste sur la précision de la détection des défauts, voire une non détection de défauts dans certains cas, en particulier pour le cas de défauts non francs.

Il existe donc un besoin pour réduire ou limiter la puissance crête de signaux multi-porteuses destinés à être utilisés par un système de réflectométrie. Une autre contrainte à respecter est d'assurer que le signal de réflectométrie généré présente de bonnes propriétés d'autocorrélation pour permettre une détection et une localisation précise des défauts.

De manière générale, des solutions pour réduire la puissance crête de signaux OFDM existent dans le domaine des systèmes de communication numérique. Cependant, elles ne prennent pas en compte les contraintes particulières des systèmes de réflectométrie et ne peuvent pas être transposées directement au diagnostic de défauts électriques.

Une première solution existante pour réduire la puissance crête de signaux multi-porteuses consiste à coder le signal avec des séquences spécifiques de signaux modulants tels que la sommation des signaux modulés réduise la puissance crête du signal. Le codage consiste à modifier de façon discrète l'amplitude et la phase de chaque sous-porteuses selon un code binaire de N bits par sous-porteuse. Cette solution est exploitable dans le domaine des communications numériques mais pas pour des signaux de réflectométrie qui ont une durée temporelle beaucoup plus réduite. Par ailleurs, elle peut nécessiter une étape de décodage en réception qui ajoute de la complexité au système de réflectométrie.

Une deuxième solution connue consiste à introduire de la distorsion dans le signal en limitant l'amplitude des pics du signal, c'est-à-dire en effectuant un écrêtage du signal. Cette méthode présente l'avantage d'être simple à mettre en œuvre mais elle engendre des distorsions dans l'intercorrélation entre le signal de réflectométrie généré et l'écho de ce signal qui est utilisé pour déterminer un réflectogramme. Un inconvénient de cette méthode est qu'elle dégrade la précision de détection des défauts à partir de l'analyse du réflectogramme.

Une troisième solution connue consiste à ajouter un signal de compensation au signal multi-porteuses, mais uniquement sur des sous-porteuses libres. De cette façon, la distorsion sur le signal est limitée. Cette méthode est par exemple décrite dans la référence [2] qui présente une application de cette solution pour des signaux OFDM utilisés dans le domaine des communications numériques. Un inconvénient de cette solution est qu'elle produit un signal dont la densité spectrale de puissance n'est pas uniforme ce qui engendre des dégradations sur le réflectogramme calculé à partir de ce signal. Cette solution n'est donc pas applicable directement au domaine de la réflectométrie.

On connait également les solutions décrites dans les documents « Multitone Signals with low crest factor, Mathias Friese, IEEE Transactions on communications, IEEE Service Center, Piscataway, NJ,USA » et « Enhancing the spatial resolution for wire fault detection systems using multi-carrier signals, Esteban Cabanillas et al, IEEE Sensors Journal, IEEE Service Center, New York, NY, US »

L'invention propose une méthode de minimisation du ratio entre la puissance crête et la puissance moyenne pour générer un signal de réflectométrie multi-porteuses par le biais d'une méthode de réservation de porteuses associée à une étape de normalisation permettant d'assurer que le signal généré présente une densité spectrale de puissance uniforme.

L'invention a pour objet une méthode de génération d'un signal de réflectométrie destiné à être injecté dans une ligne de transmission pour identifier la présence d'au moins un défaut éventuel sur la ligne, la méthode comprenant les étapes de :

- générer un premier signal numérique multi-porteuses sur un premier ensemble de porteuses fréquentielles,

- générer un second signal numérique multi-porteuses de correction sur un second ensemble de porteuses fréquentielles disjoint du premier ensemble,

- sommer le premier signal numérique et le second signal numérique de correction pour générer un signal de réflectométrie,

- normaliser les porteuses fréquentielles du signal de réflectométrie,

- le second signal numérique de correction étant déterminé de manière à réduire le ratio entre la puissance crête et la puissance moyenne du signal de réflectométrie par rapport au premier signal numérique.

Selon une variante de réalisation, la méthode selon l'invention comprend en outre une étape d'injecter le signal de réflectométrie dans une ligne de transmission.

Selon un aspect particulier de l'invention, l'étape de générer un second signal numérique de correction comprend les sous-étapes de :

- Appliquer une transformée de Fourier inverse au premier signal numérique multi-porteuses,

- Ecrêter le signal obtenu en sortie de la transformée de Fourier inverse à une valeur d'écrêtage prédéterminée,

- Appliquer une transformée de Fourier directe au signal écrêté,

- Masquer le signal de sortie de la transformée de Fourier directe de manière à mettre à zéro les fréquences des porteuses fréquentielles du premier signal numérique.

Selon un aspect particulier de l'invention, les sous-étapes permettant de générer le second signal numérique de correction sont itérées.

Selon un aspect particulier de l'invention, la valeur d'écrêtage est déterminée de manière à minimiser le ratio entre la puissance crête et la puissance moyenne du signal de réflectométrie.

Selon une variante de réalisation, la méthode selon l'invention comprend en outre une étape de sélection du nombre de porteuses fréquentielles allouées au premier signal numérique.

L'invention a aussi pour objet une méthode d'identification de la présence d'au moins un défaut éventuel sur une ligne de transmission, la méthode comprenant les étapes de :

- générer un premier signal numérique multi-porteuses sur un premier ensemble de porteuses fréquentielles,

- générer un second signal numérique multi-porteuses de correction sur un second ensemble de porteuses fréquentielles disjoint du premier ensemble,

- sommer le premier signal numérique et le second signal numérique de correction pour générer un signal de réflectométrie,

- normaliser les porteuses fréquentielles du signal de réflectométrie,

- le second signal numérique de correction étant déterminé de manière à réduire le ratio entre la puissance crête et la puissance moyenne du signal de réflectométrie par rapport au premier signal numérique,

- injecter le signal de réflectométrie dans une ligne de transmission,

- acquérir et analyser l'écho dudit signal de réflectométrie réfléchi pour en déduire une information relative à la détection et/ou la localisation de discontinuité d'impédance caractéristique d'au moins un défaut.

Selon une variante de réalisation, l'étape d'analyser l'écho du signal de réflectométrie comprend les sous-étapes de :

- calculer l'intercorrélation entre le signal de réflectométrie réfléchi et le signal de réflectométrie injecté dans la ligne, pour obtenir un réflectogramme,
- analyser le réflectogramme pour identifier au moins un pic d'amplitude caractéristique de la présence d'un défaut sur la ligne.

L'invention a encore pour objet un programme d'ordinateur comportant des instructions pour l'exécution de la méthode de génération d'un signal de réflectométrie selon l'invention, lorsque le programme est exécuté par un processeur.

L'invention a encore pour objet un support d'enregistrement lisible par un processeur sur lequel est enregistré un programme comportant des instructions pour l'exécution de la méthode de génération d'un signal de réflectométrie selon l'invention, lorsque le programme est exécuté par un processeur.

L'invention a encore pour objet un dispositif de génération d'un signal de réflectométrie destiné à être injecté dans une ligne de transmission pour identifier la présence d'au moins un défaut éventuel sur la ligne, ledit dispositif comprenant des moyens adaptés pour mettre en œuvre la méthode de génération d'un signal de réflectométrie selon l'invention.

Selon une variante particulière, le dispositif de génération d'un signal de réflectométrie selon l'invention comprend un générateur de signal de réflectométrie configuré pour mettre en œuvre la méthode de génération d'un signal de réflectométrie selon l'invention, un convertisseur numérique analogique et un dispositif de couplage pour injecter le signal de réflectométrie analogique dans une ligne de transmission.

L'invention a encore pour objet un dispositif d'identification de la présence d'au moins un défaut éventuel sur une ligne de transmission, ledit dispositif comprenant des moyens adaptés pour mettre en œuvre la méthode d'identification de la présence d'au moins un défaut selon l'invention.

Selon une variante particulière, le dispositif d'identification comprend un dispositif de couplage pour acquérir un écho du signal de réflectométrie réfléchi, un convertisseur analogique numérique et un dispositif de traitement pour analyser l'écho.

D'autres caractéristiques et avantages de la présente invention apparaîtront mieux à la lecture de la description qui suit en relation aux dessins annexés suivants :

[Fig. 1] représente un schéma illustrant le principe connu de la réflectométrie temporelle et son application à la détection d'un défaut non franc,

[Fig. 2] représente un exemple de deux réflectogrammes illustrant l'allure de la signature d'un défaut non franc, l'un obtenu en injectant un signal ayant des composantes à hautes fréquences, l'autre en injectant un signal ayant des composantes à basses fréquences,

[Fig. 3] représente un schéma d'un exemple de système de réflectométrie,

[Fig. 4] représente un schéma illustrant le principe de réduction de la puissance crête d'un signal OFDM par réservation de porteuse,

[Fig. 5] illustre deux diagrammes représentant l'autocorrélation d'un signal obtenu à l'aide d'une méthode de réservation de porteuses,

[Fig. 6] représente un organigramme illustrant les étapes générales de mise en œuvre de l'invention,

[Fig. 7a] représente un schéma illustrant les étapes de mise en œuvre de l'invention selon un mode de réalisation particulier,

[Fig. 7b] représente un schéma illustrant une variante du mode de réalisation décrit à la figure 7a,

[Fig. 8] illustre deux diagrammes représentant l'autocorrélation d'un signal obtenu à l'aide de l'invention,

[Fig. 9] représente un diagramme illustrant une méthode de détermination d'un paramètre de l'invention,

[Fig. 10a] illustre, sur un diagramme, des résultats comparatifs entre un signal obtenu avec et sans l'invention dans un premier cas d'application,

[Fig. 10b] illustre, sur un diagramme, des résultats comparatifs entre un signal obtenu avec et sans l'invention dans un second cas d'application.

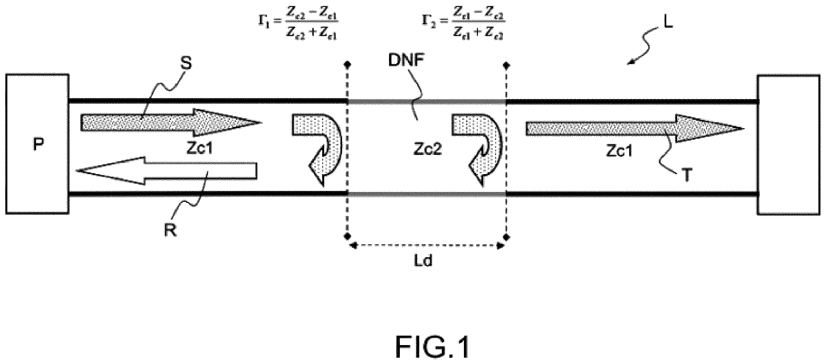

La figure 1 schématise, pour rappel, le principe de fonctionnement d'une méthode de diagnostic par réflectométrie appliquée à une ligne de transmission L présentant un défaut non-franc DNF. L'exemple décrit ci-dessous correspond à une méthode de réflectométrie temporelle.

Un signal de référence S est injecté dans la ligne de transmission en un point P. Le signal réfléchi R est mesuré au même point P (ou en un autre point de la ligne). Ce signal se propage dans la ligne et rencontre, au cours de sa propagation, une première discontinuité d'impédance à l'entrée du défaut non franc DNF. Le signal se réfléchit sur cette discontinuité avec un coefficient de réflexion $\Gamma_1$. Si l'impédance caractéristique $Z_{c2}$ dans la zone du défaut non franc DNF est inférieure à l'impédance caractéristique $Z_{c1}$ avant l'apparition du défaut, alors le coefficient de réflexion $\Gamma_1$ est négatif et se traduit par un pic d'amplitude négative dans le signal réfléchi R. Dans le cas inverse, le coefficient de réflexion $\Gamma_1$ est positif et se traduit par un pic d'amplitude positive dans le signal réfléchi R.

La partie transmise T du signal incident S continue de se propager dans la ligne et rencontre ensuite une deuxième discontinuité d'impédance créant une deuxième réflexion du signal incident avec un coefficient de réflexion $\Gamma_2$ de signe opposé au premier coefficient de réflexion $\Gamma_1$. Si $\Gamma_1 < 0$ alors $\Gamma_2 > 0$. Si $\Gamma_1 > 0$ alors $\Gamma_2 < 0$.

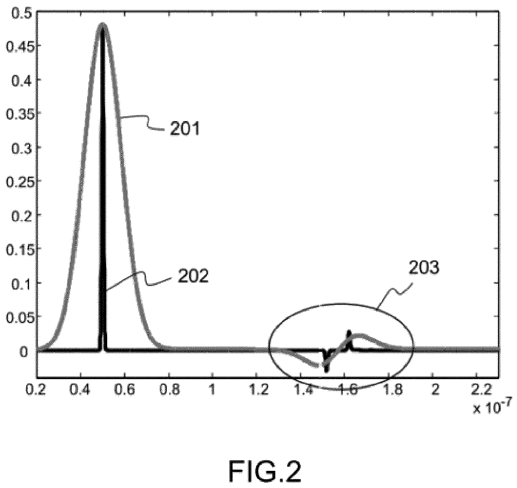

Ainsi, en observant le signal réfléchi R, la signature du défaut non franc DNF est caractérisée par deux pics successifs de signes inversés comme le montre la figure 2.

La figure 2 représente un réflectogramme temporel qui correspond soit directement à la mesure du signal réfléchi R, soit à l'intercorrélation entre le signal réfléchi R et le signal injecté dans le câble S.

Dans le cas où le signal de référence injecté est une impulsion temporelle, ce qui correspond au cas d'une méthode de réflectométrie temporelle, le réflectogramme peut correspondre directement à la mesure du signal réfléchi R. Dans le cas où le signal de référence injecté est un signal plus complexe, par exemple pour des méthodes de type MCTDR (Multi Carrier Time Domain Reflectometry) ou OMTDR (Orthogonal Multi tone Time Domain Reflectometry), alors le réflectogramme est obtenu en inter-corrélant le signal réfléchi R et le signal injecté S.

Sur la figure 2, on a représenté deux réflectogrammes 201,202 correspondants à des signaux ayant respectivement deux fréquences maximum différentes. La courbe 201 correspond à une durée d'impulsion $2.\Delta T$ très supérieure au temps de traversée, par le signal, du défaut non franc DNF. La longueur du défaut étant notée Ld, cette durée vaut Ld/V, avec V la vitesse de propagation du signal dans le câble. La courbe 202 correspond à une durée d'impulsion $2.\Delta T$ très inférieure au temps de traversée, par le signal, du défaut non franc DNF.

Dans les deux cas, la signature 203 du défaut non franc, dans le réflectogramme, est toujours composée de la succession d'un premier pic et d'un second pic dont les signes sont inversés.

La distance entre les deux pics représente la longueur du défaut non franc et leur amplitude représente la sévérité du défaut non franc. En effet, plus la variation de l'impédance caractéristique est importante, plus l'amplitude de la signature du défaut non franc dans le réflectogramme est également importante.

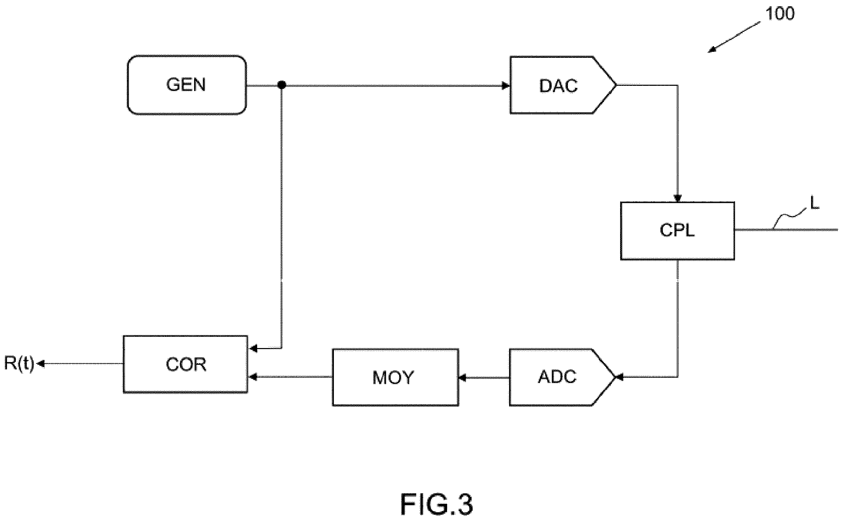

Comme cela est connu dans le domaine des méthodes de diagnostic par réflectométrie, la position $d_{DNF}$ du défaut non franc sur le câble, autrement dit sa distance au point P d'injection du signal, peut être directement obtenue à partir de la mesure, sur le réflectogramme temporel de la figure 2, de la durée $t_{DNF}$ entre le premier pic d'amplitude relevé sur le réflectogramme (à l'abscisse 0,5 sur l'exemple de la figure 3) et le pic d'amplitude 203 correspondant à la signature du défaut non franc.

Différentes méthodes connues sont envisageables pour déterminer la position $d_{DNF}$. Une première méthode consiste à appliquer la relation liant distance et temps : $d_{DNF} = V.t_{DNF}$ où V est la vitesse de propagation du signal dans le câble. Une autre méthode possible consiste à appliquer une relation de proportionnalité du type $d_{DNF}/t_{DNF} = L/t_0$ où L est la longueur du câble et $t_0$ est la durée, mesurée sur le réflectogramme, entre le pic d'amplitude correspondant à la discontinuité d'impédance au point d'injection et le pic d'amplitude correspondant à la réflexion du signal sur l'extrémité du câble.

La figure 3 représente un schéma d'un système 100 d'analyse de défaut dans une ligne de transmission L, telle qu'un câble. Le système 100 est apte à mettre en œuvre l'invention. Un tel système comprend principalement un générateur GEN d'un signal de référence. Le signal de référence numérique généré est converti analogiquement via un convertisseur numérique-analogique DAC puis est injecté en un point de la ligne de transmission L au moyen d'un coupleur CPL ou tout autre dispositif permettant d'injecter un signal dans une ligne. Le signal se propage le long de la ligne et se réfléchit sur les singularités qu'elle comporte. En l'absence de défaut sur la ligne, le signal se réfléchit sur l'extrémité de la ligne si la terminaison de la ligne est non adaptée. En présence de défaut sur la ligne, le signal se réfléchit sur la discontinuité d'impédance provoquée par le défaut. Le signal réfléchi est rétro-propagé jusqu'à un point de mesure, qui peut être commun au point d'injection ou différent. Le signal rétro-propagé est converti numériquement par un convertisseur analogique numérique ADC. Optionnellement, un moyenneur MOY est ajouté en sortie du convertisseur ADC. Une corrélation COR est ensuite effectuée entre le signal numérique mesuré et une copie du signal numérique généré avant injection afin de produire un réflectogramme temporel R(t) correspondant à l'intercorrélation entre les deux signaux.

En outre, une unité de traitement (non représentée à la figure 3), de type ordinateur, assistant numérique personnel ou autre est utilisée pour piloter le système de réflectométrie et afficher les résultats des mesures sur une interface homme-machine.

Les résultats affichés peuvent comprendre un ou plusieurs réflectogrammes calculés à l'aide du procédé selon l'invention et/ou une information relative à l'existence et à la localisation d'un défaut sur le câble également produite par le procédé selon l'invention. Les résultats affichés peuvent aussi comprendre une ou plusieurs bandes de fréquence sélectionnés par l'invention pour être utilisée(s) pour le diagnostic de défauts sur un câble donné.

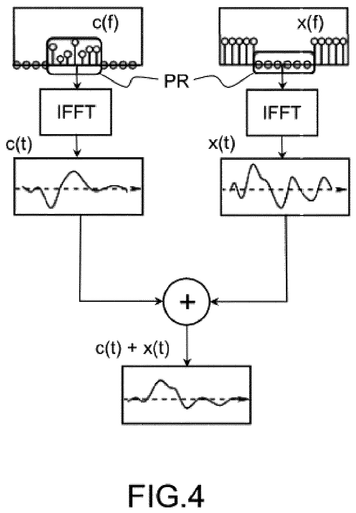

La figure 4 schématise le principe général d'une méthode de réduction du ratio entre puissance crête et puissance moyenne, par réservation de porteuses. Par la suite on utilise le terme facteur crête ou l'acronyme PAPR signifiant « Peak to Average Power Ratio » pour désigner le rapport entre la puissance crête d'un signal, c'est-à-dire sa puissance maximale et sa puissance moyenne.

Le principe général de cette méthode, appliquée à un signal multi-porteuses de type OFDM, consiste à réserver une partie PR des porteuses à un signal de compensation c(t) qui est ajouté au signal utile x(t) de sorte à réduire l'amplitude maximale des pics du signal résultant.

Comme schématisé sur la figure 4, le signal de compensation c(t) est généré sur un ensemble PR de porteuses disjoint de l'ensemble de porteuses sur lequel est généré le signal utile x(t). Autrement dit, les porteuses de l'ensemble PR sont réservées à l'ajout d'un signal de compensation c(t). Le nombre de porteuses de l'ensemble PR est un paramètre de la méthode.

Les deux signaux c(t) et x(t) sont sommés pour produire le signal OFDM modifié qui présente un facteur crête réduit par rapport au signal x(t) initial.

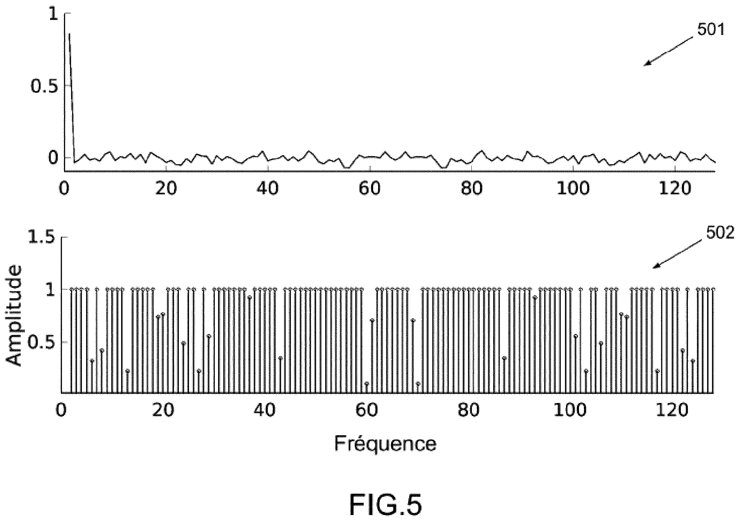

La méthode décrite à la figure 4 est utilisable pour des signaux OFDM destinés à être utilisés pour des systèmes de communications, notamment des systèmes de communications radio. Cependant, ils ne peuvent pas être utilisés directement en tant que signaux de réflectométrie pour les raisons illustrées à la figure 5.

Sur la figure 5, on a représenté, sur le diagramme 502, un exemple de spectre d'un signal OFDM obtenu par application de la méthode de la figure 4. Les porteuses réservées au signal de compensation c(t) sont représentées en gras. Sur le diagramme 501, on a représenté la fonction d'autocorrélation du signal. Du fait que la densité spectrale de puissance du signal obtenu n'est pas uniforme, la fonction d'autocorrélation présente des lobes secondaires qui génèrent un niveau de distorsion non négligeable. Or, pour des applications de réflectométrie, il est crucial que le signal utilisé présente de bonnes propriétés d'autocorrélation, c'est-à-dire avec un niveau de distorsion le plus faible possible autour du pic d'autocorrélation principal. En effet, un inconvénient du signal représenté à la figure 5 est qu'il ne permet pas de détecter des défauts non francs qui génèrent un écho dont l'amplitude est inférieure au bruit de distorsion de la fonction d'autocorrélation.

Pour cette raison, la méthode décrite à la figure 4 ne permet pas de générer un signal qui présente les propriétés attendues pour une application de réflectométrie.

Pour résoudre ce problème, il est proposé d'ajouter une étape de normalisation du signal généré au moyen de la méthode de la figure 4, de sorte à rendre uniforme la densité de puissance du signal et de limiter le bruit de distorsion de la fonction d'autocorrélation.

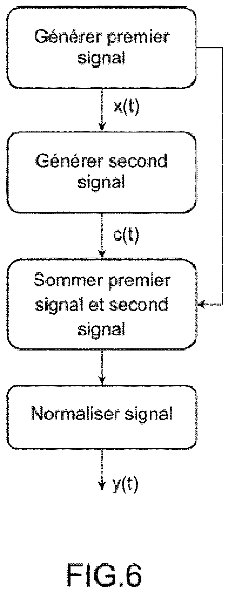

Les étapes principales du procédé selon l'invention sont décrites à la figure 6. Les étapes 601,602,603 correspondent aux étapes déjà décrites à la figure 4. Autrement dit, dans une première étape 601, le signal utile x(t) est généré sur un premier ensemble de porteuses. Dans une deuxième étape 602, le signal de compensation c(t) est généré sur un second ensemble de porteuses disjoint du premier ensemble. Dans une troisième étape 603, les signaux x(t) et c(t) sont sommés. Selon l'invention, une quatrième étape 604 de normalisation du signal est ajoutée de manière à uniformiser la densité spectrale de puissance.

Le signal de réflectométrie obtenu par application du procédé selon l'invention peut être pré-calculé et stocké dans une mémoire avant d'être injecté dans la ligne de transmission au moyen du dispositif de la figure 3. Alternativement, l'invention peut être mise en œuvre directement au sein du générateur GEN de signal.

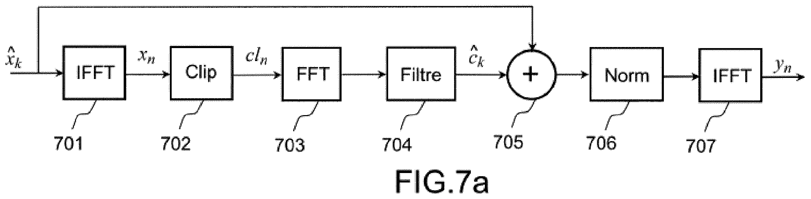

La figure 7a schématise les étapes d'un exemple de réalisation du procédé selon l'invention. Le signal utile $x_k$ est reçu en entrée du procédé, on lui applique une transformée de Fourier inverse 701 pour ramener le signal dans le domaine temporel $x_n$. Une étape d'écrê-

tage 702 est ensuite appliquée au signal. Cette étape 702 consiste à écrêter le signal à une valeur seuil prédéterminée A en appliquant les relations suivantes :

[Math. 1]

$$cl_n = x_k, si \ |x_k| \leq A$$
$$cl_n = A.sign(x_k), |x_k| > A$$

Sign() désigne la fonction signe et |.| désigne la fonction valeur absolue.

Le signal écrêté $cl_n$ est ensuite converti 703 dans le domaine fréquentiel via une transformée de Fourier directe. Une étape de filtrage 704 ou masquage est ensuite appliquée au signal pour mettre à zéro les porteuses réservées au signal utile afin de produire le signal de compensation $c_k$ qui est ensuite sommé 705 au signal utile $x_k$. Ensuite on applique une étape de normalisation 706 au signal résultant puis une étape 707 de transformée de Fourier indirecte pour convertir le signal normalisé dans le domaine temporel et produire le signal de réflectométrie $y_n$ final. L'étape de normalisation 706 consiste, par exemple, à normaliser l'amplitude de chaque sous-porteuse à 1, en conservant la valeur de la phase.

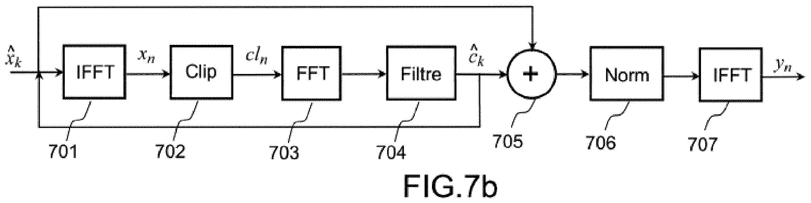

Dans une variante de réalisation illustrée à la figure 7b, les étapes 701 à 705 sont itérées une ou plusieurs fois de sorte à améliorer le facteur crête. Autrement dit, à l'issue d'une itération, le signal de sortie de la somme 705 est réinjecté en entrée du procédé à la place du signal utile $x_k$ initial.

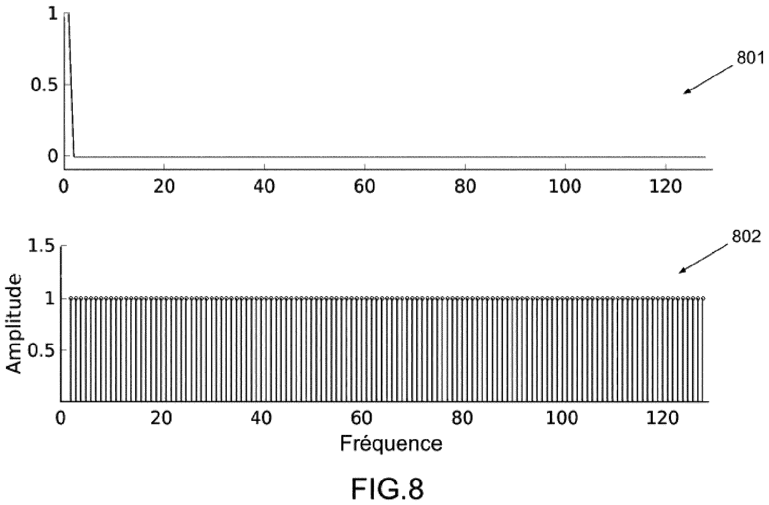

La figure 8 illustre les propriétés du signal de réflectométrie obtenu à l'aide du procédé selon l'invention. Le diagramme 802 représente le spectre du signal obtenu. Les porteuses réservées au signal de compensation $c_k$ sont en gras. Toutes les porteuses sont normalisées, ce qui permet d'obtenir une densité spectrale de puissance uniforme pour ce signal. Le diagramme 801 représente la fonction d'autocorrélation du signal. Les distorsions visibles sur le diagramme 501 sont supprimées. La fonction d'autocorrélation 801 est sensiblement nulle au-delà du pic d'autocorrélation. Ainsi, le signal obtenu grâce à l'invention est exploitable pour réaliser une analyse de défaut par réflectométrie.

Un paramètre de l'invention est le seuil d'écrêtage A de l'étape 702. La valeur de ce seuil a une incidence sur le facteur d'écrêtage. Un autre paramètre de l'invention qui influe également sur le facteur d'écrêtage est le nombre de porteuses réservées au signal de compensation. Enfin, l'étape de normalisation 706 ajoutée par l'invention a également une influence sur le facteur d'écrêtage.

Dans un mode de réalisation de l'invention, le nombre de porteuses réservées est fixé à priori, par exemple à partir de contraintes propres au signal utile.

Dans un autre mode de réalisation, le nombre de porteuses réservées est fixé par simulation de sorte à sélectionner le nombre qui permet d'obtenir le facteur d'écrêtage le plus optimal.

De même, la valeur A du seuil d'écrêtage est déterminée par simulation de sorte à minimiser le facteur d'écrêtage, c'est-à-dire à minimiser le ratio entre puissance crête et puissance moyenne du signal.

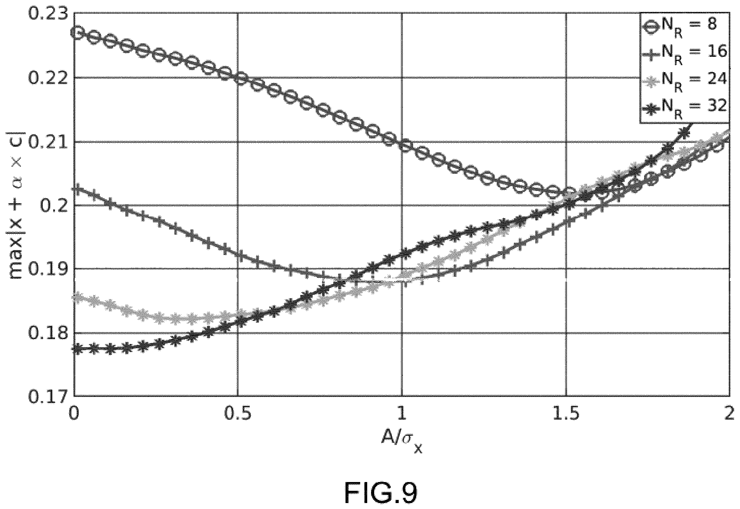

La figure 9 représente, sur un diagramme, plusieurs courbes donnant l'amplitude (en valeur absolue) maximale du signal en fonction du seuil d'écrêtage A normalisé par la puissance moyenne $\sigma_x$ du signal utile. Les quatre courbes représentées sont obtenues par simulation pour des nombres de porteuses réservées $N_R$ respectivement égaux à 8, 16, 24 et 32 pour un nombre total de porteuses égal à 64.

Ces courbes de simulation permettant de sélectionner le meilleur compromis pour le choix du nombre de porteuses réservées et de la valeur du seuil d'écrêtage de sorte à obtenir le facteur crête le plus faible possible. Par exemple, pour un nombre de porteuses réservées égal à 16, une valeur de A/$\sigma_x$ égale à 1 permet d'obtenir le facteur crête le plus faible. De façon générale, une façon possible de déterminer la valeur optimale du seuil d'écrêtage consiste à construire un tableau à deux entrées qui donne la valeur du seuil d'écrêtage optimale en fonction du nombre total de porteuses et du nombre de porteuses réservées.

Les courbes de la figure 9 sont obtenues par simulation en modélisant le signal obtenu par application de l'invention de la façon suivante :

$$y_n = x_n + \alpha c_n + d_n,$$

avec $x_n$ le signal utile initial et $c_n$ le signal de compensation.

L'effet de l'étape de normalisation 706 peut être modélisé par la composante $\alpha c_n + d_n$ où $\alpha$ est un facteur d'amplification lié à la normalisation et $d_n$ est un bruit de normalisation qui peut être considéré comme étant un bruit décorrélé.

Le facteur d'amplification $\alpha$ dépend de la puissance moyenne et de la moyenne de la valeur absolue du signal de compensation.

La valeur maximale du signal (ordonnée du diagramme de la figure 9) peut ainsi être estimée par la valeur maximale de $|x + \alpha c|$.

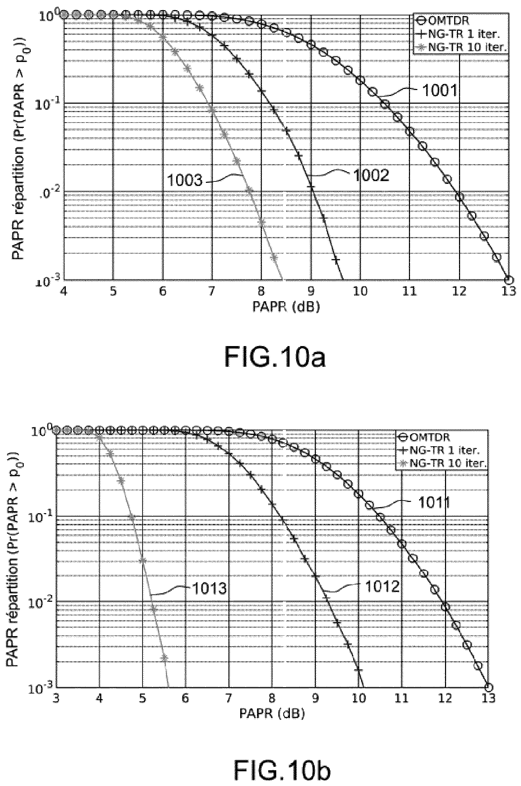

Les figures 10a et 10b représentent la fonction de répartition du facteur crête (ou PAPR) en fonction de la valeur du facteur crête en dB. La fonction de répartition donne la probabilité que la puissance du signal dépasse une certaine valeur $p_0$ exprimée en décibels en abscisse.

La figure 10a illustre des résultats obtenus pour un nombre de porteuses réservées égal à 12 sur 64. La courbe 1001 est obtenue pour un signal de type OMTDR (Orthogonal Multicarrier Time Domain Reflectometry) basé sur un signal multi-porteuses OFDM sans utiliser de méthode de réduction du facteur crête. La courbe 1002 est obtenue pour un signal généré à l'aide de l'invention. La courbe 1003 est obtenue pour un signal généré à l'aide de l'invention et en appliquant 10 itérations des étapes 701-704. On peut voir que l'invention permet un gain significatif (de l'ordre de 4dB pour une probabilité de $10^{-2}$ et 10 itérations) sur la réduction du facteur crête.

La figure 10b illustre le même type de résultats obtenus pour un nombre de porteuses réservées égal à 32 sur 64. La courbe 1011 est obtenue pour un signal de type OMTDR (Orthogonal Multicarrier Time Domain Reflectometry) basé sur un signal multi-porteuses OFDM sans utiliser de méthode de réduction du facteur crête. La courbe 1012 est obtenue pour un signal généré à l'aide de l'invention. La courbe 1013 est obtenue pour un signal généré à l'aide de l'invention et en appliquant 10 itérations des étapes 701-704.

L'invention présente l'avantage de réduire le facteur crête d'un signal de réflectométrie multi-porteuses tout en conservant une fonction d'autocorrélation compatible d'une application de réflectométrie.

Le procédé selon l'invention peut être mis en œuvre en tant que programme d'ordinateur, le procédé étant appliqué pour générer un signal de réflectométrie destiné à être utilisé au sein d'un système de réflectométrie du type de celui décrit à la figure 3. L'invention peut être mise en œuvre en tant que programme d'ordinateur comportant des instructions pour son exécution. Le programme d'ordinateur peut être enregistré sur un support d'enregistrement lisible par un processeur.

La référence à un programme d'ordinateur qui, lorsqu'il est exécuté, effectue l'une quelconque des fonctions décrites précédemment, ne se limite pas à un programme d'application s'exécutant sur un ordinateur hôte unique. Au contraire, les termes programme d'ordinateur et logiciel sont utilisés ici dans un sens général pour faire référence à tout type de code informatique (par exemple, un logiciel d'application, un micro logiciel, un microcode, ou toute autre forme d'instruction d'ordinateur) qui peut être utilisé pour programmer un ou plusieurs processeurs pour mettre en œuvre des aspects des techniques décrites ici. Les moyens ou ressources informatiques peuvent notamment être distribués ("*Cloud computing"*), éventuellement selon des technologies de pair-à-pair. Le code logiciel peut être exécuté sur n'importe quel processeur approprié (par exemple, un microprocesseur) ou cœur de processeur ou un ensemble de processeurs, qu'ils soient prévus dans un dispositif de calcul unique ou répartis entre plusieurs dispositifs de calcul (par exemple tels qu'éventuellement accessibles dans l'environnement du dispositif). Le code exécutable de chaque programme permettant au dispositif programmable de mettre en œuvre les processus selon l'invention, peut être stocké, par exemple, dans le disque dur ou en mémoire morte. De manière générale, le ou les programmes pourront être chargés dans un des moyens de stockage du dispositif avant d'être exécutés.

L'unité centrale peut commander et diriger l'exécution des instructions ou portions de code logiciel du ou des programmes selon l'invention, instructions qui sont stockées dans le disque dur ou dans la mémoire morte ou bien dans les autres éléments de stockage précités.

Alternativement, le générateur GEN de signal de réflectométrie selon l'invention peut aussi être mise en œuvre au moyen d'un processeur embarqué dans un dispositif de test spécifique. Le processeur peut être un processeur générique, un processeur spécifique, un circuit intégré propre à une application (connu aussi sous le nom anglais d'ASIC pour « Application-Specific Integrated Circuit ») ou un réseau de portes programmables in situ (connu aussi sous le nom anglais de FPGA pour « Field-Programmable Gate Array »). Le dispositif selon l'invention peut utiliser un ou plusieurs circuits électroniques dédiés ou un circuit à usage général. La technique de l'invention peut se réaliser sur une machine de calcul reprogrammable (un processeur ou un micro-contrôleur par exemple) exécutant un programme comprenant une séquence d'instructions, ou sur une machine de calcul dédiée (par exemple un ensemble de portes logiques comme un FPGA ou un ASIC, ou tout autre module matériel).

## Références

[1] "On Line Wire Diagnosis using Multicarrier Time Domain Reflectometry for Fault Location" de A. Lelong et M. Olivas. (Sensors Conference, IEEE, pages 751-754, Octobre 2009).

[2] "Peak power reduction for multicarrier transmission", José Tellado, John M. Cioffi, Information Systems Lab, Stanford University, Septembre 1999.

## Revendications

1. Méthode de génération d'un signal de réflectométrie destiné à être injecté dans une ligne de transmission pour identifier la présence d'au moins un défaut éventuel sur la ligne, la méthode comprenant les étapes de :

   - générer (601) un premier signal numérique multi-porteuses sur un premier ensemble de porteuses fréquentielles,
   - générer (602) un second signal numérique multi-porteuses de correction sur un second ensemble de porteuses fréquentielles disjoint du premier ensemble,
   - sommer (603) le premier signal numérique et le second signal numérique de correction pour générer un signal de réflectométrie,
   - normaliser (604) les porteuses fréquentielles du signal de réflectométrie,

- le second signal numérique de correction étant déterminé de manière à réduire le ratio entre la puissance crête et la puissance moyenne du signal de réflectométrie par rapport au premier signal numérique.

2. Méthode de génération d'un signal de réflectométrie selon la revendication 1 dans lequel l'étape de générer (602) un second signal numérique de correction comprend les sous-étapes de :

- Appliquer (701) une transformée de Fourier inverse au premier signal numérique multi-porteuses,
- Ecrêter (702) le signal obtenu en sortie de la transformée de Fourier inverse à une valeur d'écrêtage prédéterminée,
- Appliquer (703) une transformée de Fourier directe au signal écrêté,
- Masquer (704) le signal de sortie de la transformée de Fourier directe de manière à mettre à zéro les fréquences des porteuses fréquentielles du premier signal numérique.

3. Méthode de génération d'un signal de réflectométrie selon la revendication 2 dans laquelle les sous-étapes (701,702,703,704) permettant de générer le second signal numérique de correction sont itérées.

4. Méthode de génération d'un signal de réflectométrie selon l'une des revendications 2 ou 3 dans lequel la valeur d'écrêtage est déterminée de manière à minimiser le ratio entre la puissance crête et la puissance moyenne du signal de réflectométrie.

5. Méthode de génération d'un signal de réflectométrie selon l'une des revendications précédentes comprenant en outre une étape de sélection du nombre de porteuses fréquentielles allouées au premier signal numérique.

6. Méthode de génération d'un signal de réflectométrie selon l'une quelconque des revendications précédentes comprenant en outre une étape d'injecter le signal de réflectométrie dans une ligne de transmission.

7. Méthode d'identification de la présence d'au moins un défaut éventuel sur une ligne de transmission, la méthode comprenant les étapes de :

- Exécuter les étapes de la méthode de génération d'un signal de réflectométrie selon l'une quelconque des revendications 1 à 5,
- injecter le signal de réflectométrie dans une ligne de transmission,
- acquérir et analyser l'écho dudit signal de réflectométrie réfléchi pour en déduire une information relative à la détection et/ou la localisation de discontinuité d'impédance caractéristique d'au moins un défaut.

8. Méthode d'identification de la présence d'au moins un défaut selon la revendication 7 dans laquelle l'étape d'analyser l'écho du signal de réflectométrie comprend les sous-étapes de :

- calculer l'intercorrélation entre le signal de réflectométrie réfléchi et le signal de réflectométrie injecté dans la ligne, pour obtenir un réflectogramme,
- analyser le réflectogramme pour identifier au moins un pic d'amplitude caractéristique de la présence d'un défaut sur la ligne.

9. Programme d'ordinateur comportant des instructions pour l'exécution de la méthode de génération d'un signal de réflectométrie selon l'une quelconque des revendications 1 à 5, lorsque le programme est exécuté par un processeur.

10. Support d'enregistrement lisible par un processeur sur lequel est enregistré un programme comportant des instructions pour l'exécution de la méthode de génération d'un signal de réflectométrie selon l'une quelconque des revendications 1 à 5, lorsque le programme est exécuté par un processeur.

11. Dispositif de génération (GEN) d'un signal de réflectométrie destiné à être injecté dans une ligne de transmission pour identifier la présence d'au moins un défaut éventuel sur la ligne, ledit dispositif comprenant des moyens adaptés pour mettre en œuvre la méthode de génération d'un signal de réflectométrie selon l'une quelconque des revendications 1 à 6.

12. Dispositif de génération (GEN) d'un signal de réflectométrie selon la revendication 11 comprenant un générateur de signal de réflectométrie configuré pour mettre en œuvre la méthode de génération d'un signal de réflectométrie selon l'une quelconque des revendications 1 à 6, un convertisseur numérique analogique (DAC) et un dispositif de couplage (CPL) pour injecter le signal de réflectométrie analogique dans une ligne de transmission.

13. Dispositif d'identification (100) de la présence d'au moins un défaut éventuel sur une ligne de transmission, ledit dispositif comprenant des moyens adaptés pour mettre en œuvre la méthode d'identification de la présence d'au moins un défaut selon l'une des revendications 7 ou 8.

14. Dispositif d'identification (100) de la présence d'au moins un défaut éventuel sur une ligne de transmission selon la revendication 13 comprenant un dispositif de couplage (CPL) pour acquérir un écho du signal de réflectométrie réfléchi, un convertisseur analogique numérique (ADC) et un dispositif de traitement pour analyser l'écho.

**Patentansprüche**

1. Verfahren zur Erzeugung eines Reflektometriesignals, das in eine Übertragungsleitung eingespeist werden soll, um das Vorhandensein mindestens eines möglichen Fehlers auf der Leitung zu identifizieren, wobei das Verfahren die folgenden Schritte umfasst:

   - Erzeugen (601) eines ersten digitalen Mehrträgersignals auf einem ersten Satz von Frequenzträgern,
   - Erzeugen (602) eines zweiten digitalen Mehrträger-Korrektursignals auf einem zweiten Satz von Frequenzträgern, der von dem ersten Satz getrennt ist,
   - Summieren (603) des ersten digitalen Signals und des zweiten digitalen Korrektursignals, um ein Reflektometriesignal zu erzeugen,
   - Normalisieren (604) der Frequenzträger des Reflektometriesignals,
   - wobei das zweite digitale Korrektursignal so bestimmt wird, dass das Verhältnis zwischen der Spitzenleistung und der Durchschnittsleistung des Reflektometriesignals in Bezug auf das erste digitale Signal reduziert wird.

2. Verfahren zur Erzeugung eines Reflektometriesignals nach Anspruch 1, wobei der Schritt des Erzeugens (602) eines zweiten digitalen Korrektursignals die folgenden Unterschritte umfasst:

   - Anwenden (701) einer inversen Fourier-Transformation auf das erste digitale Mehrträgersignal,
   - Beschneiden (702) des aus der inversen Fourier-Transformation am Ausgang erhaltenen Signals auf einen vorbestimmten Beschneidungswert,
   - Anwenden (703) einer direkten Fourier-Transformation auf das beschnittene Signal,
   - Maskieren (704) des Ausgangssignals der direkten Fourier-Transformation, um die Frequenzen der Frequenzträger des ersten Digitalsignals auf Null zu setzen.

3. Verfahren zur Erzeugung eines Reflektometriesignals nach Anspruch 2, wobei die Teilschritte (701, 702, 703, 704) des Erzeugens des zweiten digitalen Korrektursignals wiederholt werden.

4. Verfahren zur Erzeugung eines Reflektometriesignals nach einem der Ansprüche 2 oder 3, wobei der Beschneidungswert so bestimmt wird, dass das Verhältnis zwischen der Spitzenleistung und der Durchschnittsleistung des Reflektometriesignals minimiert wird.

5. Verfahren zur Erzeugung eines Reflektometriesignals nach einem der vorstehenden Ansprüche, weiter umfassend einen Schritt des Auswählens der Anzahl der dem ersten digitalen Signal zugewiesenen Frequenzträger.

6. Verfahren zur Erzeugung eines Reflektometriesignals nach einem der vorstehenden Ansprüche, weiter umfassend einen Schritt des Einspeisens des Reflektometriesignals in eine Übertragungsleitung.

7. Verfahren zur Identifizierung des Vorhandenseins mindestens eines möglichen Fehlers in eine Übertragungsleitung, wobei das Verfahren die folgenden Schritte umfasst:

   - Ausführen der Schritte des Verfahrens zur Erzeugung eines Reflektometriesignals nach einem der Ansprüche 1 bis 5,
   - Einspeisen des Reflektometriesignals in eine Übertragungsleitung,
   - Erfassen und Analysieren des Echos des reflektierten Reflektometriesignals, um daraus Informationen hinsichtlich der Erkennung und/oder Lokalisierung einer für mindestens einen Fehler charakteristischen Impedanzdiskontinuität abzuleiten.

8. Verfahren zur Identifizierung des Vorhandenseins mindestens eines Fehlers nach Anspruch 7, wobei der Schritt des Analysierens des Echos des Reflektometriesignals die folgenden Teilschritte umfasst:

   - Berechnen der Interkorrelation zwischen dem reflektierten Reflektometriesignal und dem in die Leitung eingespeisten Reflektometriesignal, um ein Reflektogramm zu erhalten,
   - Analysieren des Reflektogramms, um mindestens einen Amplitudenpeak zu identifizieren, der für das Vorhandensein eines Fehlers auf der Leitung charakteristisch ist.

9. Computerprogramm, das Anweisungen zur Ausführung des Verfahrens zur Erzeugung eines Reflektometriesignals nach einem der Ansprüche 1 bis 5 aufweist, wenn das Programm durch einen Prozessor ausgeführt wird.

10. Von einem Prozessor lesbarer Aufzeichnungsträger, auf dem ein Programm aufgezeichnet ist, das Anweisungen zur Ausführung des Verfahrens zur Erzeugung eines Reflektometriesignals nach einem der Ansprüche 1 bis 5 aufweist, wenn das Programm durch einen Prozessor ausgeführt wird.

11. .Vorrichtung zur Erzeugung (GEN) eines Reflektometriesignals, das in eine Übertragungsleitung eingespeist werden soll, um das Vorhandensein mindestens eines möglichen Fehlers auf der Leitung zu identifizieren, wobei die Vorrichtung Mittel umfasst, die angepasst sind, um das Verfahren zur Erzeugung eines Reflektometriesignals nach einem der Ansprüche 1 bis 6 durchzuführen.

12. Vorrichtung zur Erzeugung (GEN) eines Reflektometriesignals nach Anspruch 11, umfassend einen Reflektometriesignalgenerator, der konfiguriert ist, um das Verfahren zur Erzeugung eines Reflektometriesignals nach einem der Ansprüche 1 bis 6 durchzuführen, einen Digital-Analog-Wandler (DAC) und eine Kopplungsvorrichtung (CPL) um das analoge Reflektometriesignal in eine Übertragungsleitung einzuspeisen.

13. Vorrichtung zur Identifizierung (100) des Vorhandenseins mindestens eines möglichen Fehlers auf einer Übertragungsleitung, wobei die Vorrichtung Mittel umfasst, die angepasst sind, um das Verfahren zur Identifizierung des Vorhandenseins mindestens eines Fehlers nach einem der Ansprüche 7 oder 8 durchzuführen.

14. Vorrichtung (100) zur Identifizierung des Vorhandenseins mindestens eines möglichen Fehlers auf einer Übertragungsleitung nach Anspruch 13, umfassend eine Kopplungsvorrichtung (CPL) zum Erfassen eines Echos des reflektierten Reflektometriesignals, einen Analog-Digital-Wandler (ADC) und eine Verarbeitungsvorrichtung um das Echo zu analysieren.

## Claims

1. Method for generating a reflectometry signal intended to be injected into a transmission line to identify the presence of at least one possible fault on the line, the method comprising the steps of:

   - generating (601) a first digital multi-carrier signal in a first set of frequency carriers,
   - generating (602) a second digital multi-carrier correction signal in a second set of frequency carriers separate from the first set,
   - summing (603) the first digital correction signal and the second digital correction signal to generate a reflectometry signal,
   - normalising (604) the frequency carriers of the reflectometry signal,

   - the second digital correction signal being determined so as to reduce the ratio between the peak power and the average power of the reflectometry signal relative to the first digital signal.

2. Method for generating a reflectometry signal according to claim 1, wherein the step of generating (602) a second digital correction signal comprises the substeps of:

   - applying (701) an inverse Fourier transform to the first digital multi-carrier signal,
   - capping (702) the signal obtained at the output of the inverse Fourier transform at a predetermined capping value,
   - applying (703) a direct Fourier transform to the capped signal,
   - masking (704) the output signal of the direct Fourier transform so as to reset the frequencies of the frequency carriers of the first digital signal.

3. Method for generating a reflectometry signal according to claim 2, wherein the substeps (701, 702, 703, 704) making it possible to generate the second digital correction signal are iterated.

4. Method for generating a reflectometry signal according to any one of claims 2 or 3, wherein the capping value is determined so as to minimise the ratio between the peak power and the average power of the reflectometry signal.

5. Method for generating a reflectometry signal according to any one of the preceding claims, further comprising a step of selecting the number of frequency carriers allocated to the first digital signal.

6. Method for generating a reflectometry signal according to any one of the preceding claims, further comprising a step of injecting the reflectometry signal in a transmission line.

7. Method for identifying the presence of at least one possible fault on a transmission line, the method comprising the steps of:

   - executing the steps of the method for generating a reflectometry signal according to any one of claims 1 to 5,
   - injecting the reflectometry signal in a transmission line,
   - acquiring and analysing the echo of said reflected reflectometry signal to deduce from this, information relating to detecting and/or locating the characteristic impedance discontinuity of at least one fault.

8. Method for identifying the presence of at least one fault according to claim 7, wherein the step of analysing the echo of the reflectometry signal comprises the substeps of:

   - calculating the intercorrelation between the reflected reflectometry signal and the reflectometry signal injected into the line, to obtain a reflectogram,
   - analysing the reflectogram to identify at least one characteristic amplitude peak of the presence of a fault on the line.

9. Computer program comprising code instructions for executing the method for generating a reflectometry signal according to any one of claims 1 to 5, when the program is executed by a processor.

10. Recording medium which can be read by a processor, on which a program comprising code instructions for executing the method for generating a reflectometry signal is recorded, according to any one of claims 1 to 5, when the program is executed by a processor.

11. Device for generating (GEN) a reflectometry signal intended to be injected into a transmission line to identify the presence of at least one possible fault on the line, said device comprising means adapted to implement the method for generating a reflectometry signal according to any one of claims 1 to 6.

12. Device for generating (GEN) a reflectometry signal according to claim 11 comprising a reflectometry signal generator configured to implement the method for generating a reflectometry signal according to any one of claims 1 to 6, a digital-to-analogue converter (DAC) and a coupling device (CPL) to inject the analogue reflectometry signal into a transmission line.

13. Device (100) for identifying the presence of at least one possible fault on a transmission line, said device comprising means adapted to implement the method for identifying the presence of at least one fault according to any one of claims 7 or 8.

14. Device (100) for identifying the presence of at least one possible fault on a transmission line according to claim 13 comprising a coupling device (CPL) for acquiring an echo of the reflected reflectometry signal, an analogue-to-digital converter (ADC) and a processing device for analysing the echo.

FIG.1

FIG.2

FIG.3

FIG.4

FIG.5

FIG.6

EP 3 990 933 B1

$\hat{x}_k$ → | IFFT | $x_n$ | Clip | $cl_n$ | FFT | | Filtre | $\hat{c}_k$ → ( + ) → | Norm | → | IFFT | $y_n$ →

701    702    703    704    705    706    707

## FIG.7a

FIG.7b

FIG.8

EP 3 990 933 B1

FIG.9

EP 3 990 933 B1

FIG.10a

FIG.10b

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **MATHIAS FRIESE**. Multitone Signals with low crest factor. *IEEE Transactions on communications, IEEE Service Center*
- **ESTEBAN CABANILLAS et al.** Enhancing the spatial resolution for wire fault detection systems using multi-carrier signals. *IEEE Sensors Journal, IEEE Service Center*
- **A. LELONG** ; **M. OLIVAS.** On Line Wire Diagnosis using Multicarrier Time Domain Reflectometry for Fault Location. *Sensors Conference, IEEE*, October 2009, 751-754
- **JOSÉ TELLADO** ; **JOHN M. CIOFFI**. Peak power reduction for multicarrier transmission. *Information Systems Lab*, September 1999